# EUROPEAN PATENT SPECIFICATION

(11) **EP 4 007 457 B1**
(45) Date of publication and mention of the grant of the patent: **01.05.2024**
(21) Application number: 20897277.8
(22) Date of filing: 11.11.2020
(51) Int. Cl.: H05K 1/18, H01R 12/71

(54) **CIRCUIT BOARD ASSEMBLY AND ELECTRONIC APPARATUS**
LEITERPLATTENANORDNUNG UND ELEKTRONISCHE VORRICHTUNG
ENSEMBLE CARTE DE CIRCUIT ET APPAREIL ÉLECTRONIQUE

(30) Priority: 05.12.2019 CN 201911232961
(43) Date of publication of application: 01.06.2022
(60) Divisional application: 24164750.2
(73) Proprietor: Honor Device Co., Ltd., Shenzhen, Guangdong 518040 (CN)
(72) Inventor: LUO, Fan, Shenzhen, Guangdong 518040 (CN)
(74) Representative: Epping - Hermann - Fischer
(86) International application number: PCT/CN2020/128169
(87) International publication number: WO 2021/109818

(56) References cited:
- EP-A2- 1 315 243
- WO-A1-2006/057424
- CN-A- 105 828 530
- CN-U- 204 045 775
- CN-U- 205 282 690
- CN-U- 209 329 278
- DE-A1-102015 221 146
- JP-A- 2005 251 889
- JP-B2- 5 736 227
- KR-A- 20150 139 345
- US-B1- 10 424 345

## Description

### TECHNICAL FIELD

This application relates to the field of electronic component technologies, and in particular, to a circuit board assembly and an electronic device.

### BACKGROUND

A printed circuit board (Printed Circuit Board, PCB) is an important part in an electronic product, and printed circuit boards may be connected by using a board-to-board connector (Board-to-board connectors, BTB).

Many electronic elements are disposed on the periphery of the board-to-board connector for functions such as filtering. After the board-to-board connector is connected to the printed circuit board, these electronic elements are disposed on a surface of the printed circuit board and surround the board-to-board connector. During actual production, assembly, and repair at a service center, the electronic elements are easily damaged due to impact, and consequently poor functions are caused.

CN 105 828 530 A provides a circuit board and an electronic device and relates to the technical field of electronic device manufacture. The circuit board comprises a circuit board body; a board-to-board connector arranged on the circuit board body; a patch device arranged on the circuit board body; and an anti-collision structure arranged on the circuit board body and used for isolating the patch device from the board-to-board connector.

JP 2005 251889 A relates to a shield (electromagnetic shielding) structure of a three-dimensional electronic circuit device in which a circuit board on which electronic components are mounted is relayed using a relay board or the like to form a three-dimensional structure.

WO 2006/057424 A1 relates to a first printed board on which a ground pattern is provided and an electronic part is mounted and a second printed board on which a ground pattern is provided and an electronic part is mounted which are oppositely arranged, and circuits of the first printed board and the second printed board are connected by a connector with a frame-like shield. In the connector with a shield, a frame body is formed of an insulator such as a resin, a connection terminal is provided inside the frame body, and a conductor is provided on the entire outer periphery of the frame body. In the conductor, the shield is formed by both the ground pattern of the first printed board and the ground pattern of the second printed board. The frame body shields the electronic parts.

DE 10 2015 221146 A1 relates to a circuit board assembly comprising a circuit board and an electronic component accommodated in a recess.

### SUMMARY

The invention is set out in the appended claims.

An objective of this application is to provide a circuit board assembly and an electronic device, so that peripheral electronic elements are not damaged by impact during production, assembly or repair of the board-to-board connector.

According to a first aspect, a circuit board assembly as defined in claim 1 is provided, including
a circuit board;
a backing plate fixedly connected to one side of the circuit board, where the backing plate is provided with an accommodation portion;
an electronic element accommodated in the accommodation portion and connected to the circuit board; and
a board-to-board connector fixedly connected to one side of the backing plate that is away from the circuit board.

The accommodation portion is provided on the backing plate, and the electronic element is accommodated in the accommodation portion, so that the electronic element is located in the space under the board-to-board connector. Therefore, not only damage caused by impact of the electronic element can be prevented, but also space of the circuit board assembly can be greatly saved.

The accommodation portion is a through via provided on the backing plate, and the through via passes through along a height direction of the circuit board assembly; and
the board-to-board connector covers the through via.

The through via is made on the backing plate, and the electronic element is disposed in the through via and connected to the circuit board. The process of making the through via on the backing plate is simple and can be implemented conveniently.

In a possible implementation, a first soldering pad is further included, where the electronic element is fastened and electrically connected to the circuit board by using the first soldering pad. The first soldering pad may be a soldering pad of an electronic shielding component, so that the electronic element does not interfere with work of another component.

In a possible implementation, a second soldering pad is further included, where the board-to-board connector is fixedly connected to the backing plate by using the second soldering pad. The second soldering pad is disposed so that the board-to-board connector can be further elevated, thereby further providing larger accommodation space for the electronic element.

In a possible implementation, the backing plate is provided with a first via, an inner wall of the first via is provided with a first conductive layer, the first conductive layer is electrically connected to the board-to-board connector by using the second soldering pad, and the first conductive layer is electrically connected to the circuit board. The first conductive layer is provided to facilitate electrical connection between the board-to-board connector and the circuit board.

Copper may be plated in the first via to form the first conductive layer.

In a possible implementation, the circuit board is provided with a second via, and an inner wall of the second via is provided with a second conductive layer; and
the second conductive layer is electrically connected to the electronic element.

The second via and the second conductive layer are provided so that the electronic element can be led out to be connected to another related component, so as to meet a design requirement of a circuit.

Copper may be plated in the second via to form the second conductive layer.

In a possible implementation, the circuit board is provided with a third via, and the third via communicates with the first via;
an inner wall of the third via is provided with a third conductive layer, and the third conductive layer is electrically connected to the first conductive layer; and
the circuit board is further provided with a fourth conductive layer, and the fourth conductive layer is electrically connected to the third conductive layer and the second conductive layer separately.

Copper may be plated in the third via to form the third conductive layer. The fourth conductive layer may be buried in the circuit board, to electrically connect the third conductive layer to the second conductive layer.

According to another aspect, an electronic device is provided, including more than two circuit board assemblies, where each of the more than two circuit board assemblies includes a board-to-board connector, the more than two circuit board assemblies are connected by using respective board-to-board connectors, and at least one circuit board assembly is the circuit board assembly as defined in claim 1.

At least one circuit board assembly is arranged as the circuit board assembly provided in this application, so that the at least one circuit board assembly saves space occupied by an electronic element, thereby facilitating miniaturization and thinning of a mobile phone.

The technical solutions provided in this application may achieve the following beneficial effects: In the circuit board assembly and the electronic device provided in this application, the electronic element is accommodated in the accommodation portion, and the accommodation portion may be provided on the backing plate, so that the electronic element is located in the space under the board-to-board connector. Therefore, not only damage caused by impact of the electronic element can be prevented, but also space of the circuit board assembly can be greatly saved, thereby facilitating miniaturization and thinning of the electronic device.

### BRIEF DESCRIPTION OF DRAWINGS

FIGs. 3-6 are not according to the invention and present for illustrative purposes only.
FIG. 1 is a schematic exploded diagram of a structure of a circuit board assembly according to an embodiment of this application;
FIG. 2 is a sectional drawing of a structure of a circuit board assembly according to an embodiment of this application;
FIG. 3 is a sectional drawing of a structure of a circuit board assembly;
FIG. 4 is a sectional drawing of a structure of a circuit board assembly;
FIG. 5 is a sectional drawing of a structure of a circuit board assembly; and
FIG. 6 is a sectional drawing of a structure of a circuit board assembly.

### Reference numerals:

100: Circuit board assembly;
Circuit board;
11: Second via;
12: Second conductive layer;
13: Third via;
14: Third conductive layer;
15: Fourth conductive layer;
2: Backing plate;
21: Accommodation portion;
211: Shield layer;
22: First via;
23: First conductive layer;
3: Electronic element;
4: Board-to-board connector;
5: First soldering pad;
6: Second soldering pad;
200: Circuit board assembly;
10: Circuit board;
20: Board-to-board connector;
201: Body;
201a: Accommodation portion;
202: Conductive portion;
30: Electronic element.

### DESCRIPTION OF EMBODIMENTS

The terms used in the embodiments of this application are merely for the purpose of illustrating specific embodiments, and are not intended to limit this application. The terms "a", "said" and "the" of singular forms used in the embodiments and the appended claims of this application are also intended to include plural forms, unless otherwise specified in the context clearly.

It should be understood that the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It should be noted that, direction terms such as "top", "bottom", "left", and "right" described in the embodiments of this application are described from an angle shown in the accompanying drawings, and should not be construed as a limitation to the embodiments of this application. In addition, in the context, it should be further noted that, when it is mentioned that an element is connected to the "top" or "bottom" of another element, the element cannot only be directly connected to the "top" or "bottom" of the another element, but may also be indirectly connected to the "top" or "bottom" of the another element by using an intermediate element.

An embodiment of this application provides an electronic device. The electronic device may be a mobile phone, a tablet computer, or another electronic product. These electronic devices usually include mainboards. A mobile phone is used as an example, a mainboard may be connected to a circuit board of a component such as a camera, a battery, or a USB by using a board-to-board connector, and other circuit boards may also be connected by using board-to-board connectors. An electronic element such as a capacitor, an inductor, or a resistor is disposed on the periphery of the board-to-board connector. With deeper development of an integrated and miniaturized design of the mobile phone, layout space of the mainboard or other circuit boards becomes increasingly limited, and these electronic elements are easily damaged by impact during assembly or repair. A circuit board assembly and the electronic device provided in the embodiments of this application can resolve the technical problem that layout space of a circuit board is limited and electronic elements are damaged.

An embodiment of this application provides an electronic device, including more than two circuit board assemblies, where one circuit board assembly may include a mainboard of the electronic device, and other circuit board assemblies may include other circuit boards on the electronic device. Each of the more than two circuit board assemblies may include a board-to-board connector, and the more than two circuit board assemblies are connected by using respective board-to-board connectors. At least one circuit board assembly is the circuit board assembly provided in any embodiment of this application.

In other words, in the electronic device provided in this embodiment of this application, at least one circuit board assembly has a compact layout structure, so that space occupied by electronic elements can be reduced, thereby implementing miniaturization and thinning of the electronic device, and preventing the electronic elements from being damaged by impact during assembly and repair.

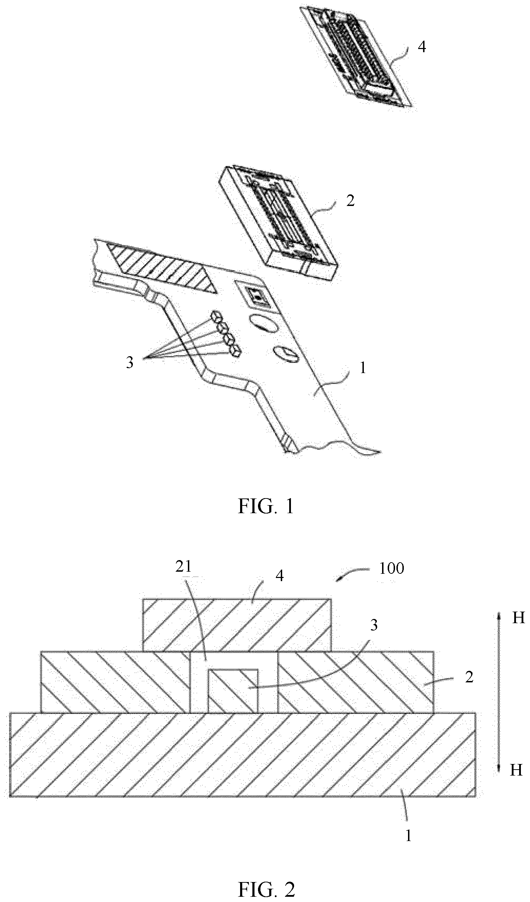

FIG. 1 is a schematic exploded diagram of a structure of a circuit board assembly according to an embodiment of this application. This embodiment of this application provides a circuit board assembly 100, including a circuit board 1, a backing plate 2, one or more electronic elements 3, and a board-to-board connector 4. The electronic elements 3 in this embodiment of this application may include one or more electronic elements.

FIG. 2 is a sectional drawing of a structure of a circuit board assembly according to an embodiment of this application. Referring to the circuit board assembly 100 in FIG. 1 and FIG. 2, the backing plate 2 is fixedly connected to one side of the circuit board 1. In a possible implementation, the backing plate 2 may be fastened to one side of the circuit board 1 through welding, and the backing plate 2 is provided with an accommodation portion 21.

The electronic element 3 is accommodated in the accommodation portion 21 and connected to the circuit board 1. In a possible implementation, the electronic element 3 may be welded to the circuit board 1, so that not only the electronic element 3 can be fastened, but also the electronic element 3 can be electrically connected to the circuit board 1.

The board-to-board connector 4 is fixedly connected to one side that is of the backing plate 2 and that is away from the circuit board 1. In a possible implementation, the board-to-board connector 4 may be fastened to the backing plate 2 through welding.

The electronic element 3 may be a filtering element, such as an electronic element having a function of a capacitive component, a resistive component, a common-mode inductor, or a protection diode (such as a TVS), used for the board-to-board connector 4. In a height direction H in FIG. 2, the electronic element 3 is accommodated in the interior space (namely, the accommodation portion 21) of the backing plate 2 under the board-to-board connector 4. Therefore, not only damage caused by impact of the electronic element 3 can be prevented, but also space of the circuit board assembly 100 can be greatly saved.

As shown in FIG. 2, in a specific implementation, the accommodation portion 21 may be a through via provided on the backing plate 2, the through via passes through the backing plate 2 along the height direction H of the circuit board assembly 100, and the board-to-board connector 4 covers the through via.

In this embodiment, the through via is made on the backing plate 2, the electronic element 3 is disposed in the through via, and the electronic element 3 may be welded to the circuit board 1, so that the electronic element 3 can be fixedly connected to the circuit board 1, and can also be electrically connected to the circuit board 1. The process of making the through via on the backing plate 2 is simple and can be implemented conveniently. The electronic element 3 may include an electronic element having a function of a capacitive component, a resistive component, a common-mode inductor, or a protection diode (such as a TVS). According to an actual design requirement, some of these electronic elements may be disposed in the accommodation portion 21, or all of these electronic elements may be disposed in the accommodation portion 21. This is not limited herein.

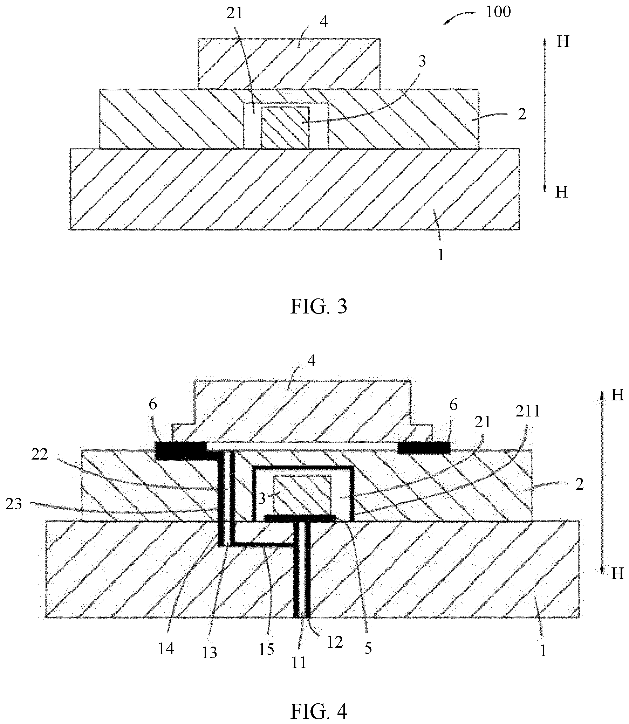

FIG. 3 is a sectional drawing of a structure of a circuit board assembly not part of the claimed invention.

As shown in FIG. 3, in a specific implementation, an accommodation portion 21 may be a blind via provided on the backing plate 2, and the blind via is recessed from one side that is of the backing plate 2 and that is close to the circuit board 1 to one side close to the board-to-board connector 4.

In other words, in a height direction of the circuit board assembly 100, the accommodation portion 21 does not pass through the backing plate 2. This structure can shield the electronic element to a certain extent, and is applicable to an electronic element with a shielding requirement.

FIG. 4 is a sectional drawing of a structure of a circuit board assembly according to still another embodiment not part of the claimed invention.

As shown in FIG. 4, in a specific implementation, an inner wall of the accommodation portion 21 may be provided with a shield layer 211. The shield layer 211 is provided to further shield the electronic element 3, thereby improving a filtering effect of a filtering component. The shield layer 211 may be formed by plating gold and nickel on a copper layer.

Still referring to FIG. 4, in a specific implementation, a first soldering pad 5 is disposed between the circuit board 1 and the electronic element 3, and the electronic element 3 is fastened and electrically connected to the circuit board 1 by using the first soldering pad 5. The first soldering pad 5 may be a soldering pad of an electronic shielding component. The first soldering pad 5 is disposed so that the electronic element 3 can be fastened and electrically connected to the circuit board 1. In addition, the first soldering pad 5 can further enable the electronic element 3 not to interfere with work of another component.

Still referring to FIG. 4, in a specific implementation, a second soldering pad 6 may be further disposed between the backing plate 2 and the board-to-board connector 4, and the board-to-board connector 4 is fixedly connected to the backing plate 2 by using the second soldering pad 6. The second soldering pad 6 is disposed so that the board-to-board connector 4 can be further elevated, thereby further providing larger accommodation space for the electronic element 3.

In a specific implementation, the backing plate 2 is provided with a first via 22, an inner wall of the first via 22 is provided with a first conductive layer 23, the first conductive layer 23 is electrically connected to the board-to-board connector 4 by using the second soldering pad 6, and the first conductive layer 23 is electrically connected to the circuit board 1. The first conductive layer 23 is provided to facilitate electrical connection between the board-to-board connector 4 and the circuit board 1. For example, copper may be plated in the first via 22 to form the first conductive layer 23.

Specifically, the first conductive layer 23 may be electrically connected to the second soldering pad 6, so that the first conductive layer 23 can be electrically connected to the board-to-board connector 4. The first conductive layer 23 may also be connected to the circuit board 1 by using a soldering pad or in another manner. This is not limited herein.

In a specific implementation, the circuit board 1 is provided with a second via 11, an inner wall of the second via 11 is provided with a second conductive layer 12, and the second conductive layer 12 is electrically connected to the electronic element 3.

The second via 11 and the second conductive layer 12 are provided so that the electronic element 3 can be led out to be connected to another related component, so as to meet a design requirement of a circuit. Copper may be plated in the second via 11 to form the second conductive layer 12.

As mentioned above, the first conductive layer 23 is provided to facilitate electrical connection between the board-to-board connector 4 and the circuit board 1. The first conductive layer 23 may be connected to the board-to-board connector 4 by using the second soldering pad 6 and connected to the circuit board 1 and the electronic element 3 by using the second conductive layer 12.

In a specific implementation, the circuit board 1 is provided with a third via 13, the third via 13 communicates with the first via 22, an inner wall of the third via 13 is provided with a third conductive layer 14, and the third conductive layer 14 is electrically connected to the first conductive layer 23. The circuit board 1 is further provided with a fourth conductive layer 15, and the fourth conductive layer 15 is electrically connected to the third conductive layer 14 and the second conductive layer 12 separately.

Copper may be plated in the third via 13 to form the third conductive layer 14. The fourth conductive layer 15 may be buried in the circuit board 1, to electrically connect the third conductive layer 14 to the second conductive layer 12. In the embodiment shown in FIG. 4, the board-to-board connector 4 is connected to the first soldering pad 5 by using the second soldering pad 6, the first conductive layer 23, the third conductive layer 14, the fourth conductive layer 15, and the second conductive layer 12.

During use, a board-to-board connector of another circuit board assembly is connected to the board-to-board connector 4 in the embodiment shown in FIG. 4, so that the another circuit board assembly can be connected to the circuit board assembly 100 in the embodiment shown in FIG. 4.

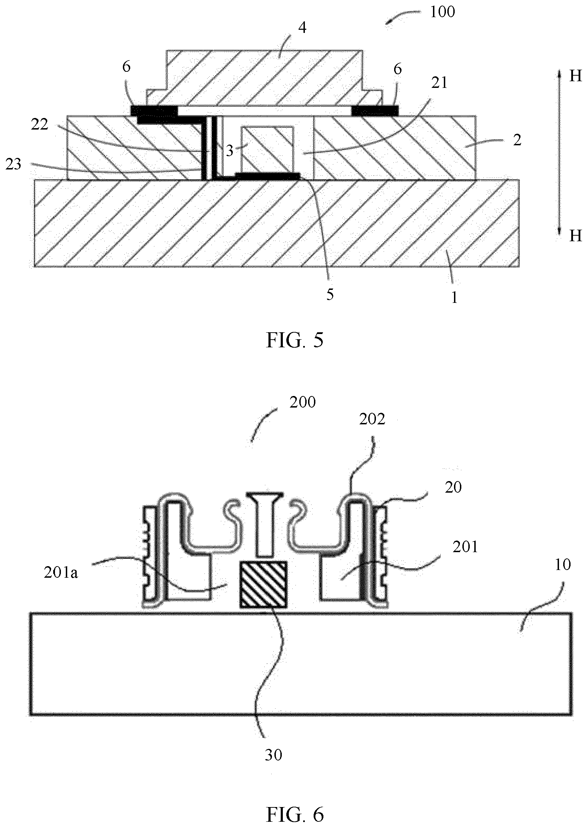

FIG. 5 is a sectional drawing of a structure of a circuit board assembly according to yet another embodiment of this application. In the embodiment shown in FIG. 5, an accommodation portion 21 of the backing plate 2 of the circuit board assembly 100 is a through via, and is applicable to an electronic device without a shielding requirement. In this embodiment, the circuit board assembly 100 may also include a first soldering pad 5 and/or a second soldering pad 6. A structure and a form of the first soldering pad 5 and the second soldering pad 6 may be the same as those in the embodiment shown in FIG. 4, and details are not described herein again.

The backing plate 2 may also be provided with a first via 22, an inner wall of the first via 22 is provided with a first conductive layer 23, and the first conductive layer 23 may be electrically connected to the first soldering pad 5.

FIG. 6 is a sectional drawing of a structure of a circuit board assembly according to still yet another embodiment not part of the claimed invention.

As shown in FIG. 6, the circuit board assembly 200 provided in this embodiment of this application includes a circuit board 10, a board-to-board connector 20, and an electronic element 30. The board-to-board connector 20 is electrically connected to the circuit board 10. The board-to-board connector 20 includes a body 201 and a conductive portion 202. An accommodation portion 201a is provided inside the body 201, the conductive portion 202 is embedded in the body 201, the electronic element 30 is connected to the circuit board 10, and the electronic element 30 is accommodated in the accommodation portion 201a.

The board-to-board connector 20 is electrically connected to the circuit board 10 by using the conductive portion 202, or may be electrically connected to a board-to-board connector in another circuit board assembly by using the conductive portion 202. In this embodiment, the body 201 is a plastic body, the conductive portion 202 is a metal spring, and the metal spring is embedded in the plastic body.

In this embodiment, a height of the body 201 may be increased, so that the body has space for disposing the accommodation portion 201a. The accommodation portion 201a may be a groove or a through groove provided on the body 201. In the embodiment shown in FIG. 6, the accommodation portion 201a is an internal through groove provided at a central position of the body 201, and the electronic element 30 is accommodated in the accommodation portion 201a and connected to the circuit board 10

It may be understood that the embodiment shown in FIG. 6 is merely an example, and the electronic element 30 and the circuit board 10 may also be connected by providing a structure such as a soldering pad or a conductive layer. A shield layer may also be provided according to a design requirement of a circuit board.

An embodiment of this application further provides an electronic device, including more than two circuit board assemblies. Each of the more than two circuit board assemblies includes a board-to-board connector, and the more than two circuit board assemblies are connected by using respective board-to-board connectors. At least one circuit board assembly is the circuit board assembly provided in any embodiment of this application.

In a specific implementation, the electronic device may be a mobile phone. A circuit board assembly includes a mainboard and a board-to-board connector that cooperates with the mainboard, and another circuit board assembly includes a drive circuit board of a camera and a board-to-board connector that cooperates with the drive circuit board. The two board-to-board connectors cooperate with each other to implement connection between the mainboard and the drive circuit board of the camera. In the two circuit board assemblies, at least one circuit board assembly is the circuit board assembly provided in the embodiments of this application, so that the at least one circuit board assembly saves space occupied by an electronic element, thereby facilitating miniaturization and thinning of the mobile phone.

## Claims

1. A circuit board assembly, comprising:
a circuit board (1);
a backing plate (2) fixedly connected to one side of the circuit board (1), wherein the backing plate (2) is provided with an accommodation portion (21);
an electronic element (3) accommodated in the accommodation portion (21) and connected to the circuit board (1); and
a board-to-board connector (4) fixedly connected to one side of the backing plate (2) that is away from the circuit board (1),
**characterised in that** the accommodation portion (21) is a through via provided on the backing plate (2), and the through via passes through along a height direction of the circuit board assembly; and
the board-to-board connector (4) covers the through via.

2. The circuit board assembly according to claim 1, further comprising a first soldering pad (5), wherein the electronic element (3) is fastened and electrically connected to the circuit board (1) by using the first soldering pad (5).

3. The circuit board assembly according to claim 1, further comprising a second soldering pad (6), wherein the board-to-board connector (4) is fixedly connected to the backing plate (2) by using the second soldering pad (6).

4. The circuit board assembly according to claim 3, wherein the backing plate (2) is provided with a first via (22), an inner wall of the first via (22) is provided with a first conductive layer (23), the first conductive layer (23) is electrically connected to the board-to-board connector (4) by using the second soldering pad (6), and the first conductive layer (23) is electrically connected to the circuit board (1).

5. The circuit board assembly according to claim 4, wherein the circuit board (1) is provided with a second via (11), and an inner wall of the second via (11) is provided with a second conductive layer (12); and
the second conductive layer (12) is electrically connected to the electronic element (3).

6. The circuit board assembly according to claim 5, wherein the circuit board (1) is provided with a third via (13), and the third via (13) communicates with the first via (22);
an inner wall of the third via (13) is provided with a third conductive layer (14), and the third conductive layer (14) is electrically connected to the first conductive layer (23); and
the circuit board (1) is further provided with a fourth conductive layer (15), and the fourth conductive layer (15) is electrically connected to the third conductive layer (14) and the second conductive layer (12) separately.

7. An electronic device, comprising more than two circuit board assemblies, wherein each of the more than two circuit board assemblies comprises a board-to-board connector, the more than two circuit board assemblies are connected by using respective board-to-board connectors, and at least one circuit board assembly is the circuit board assembly according to any one of claims 1 to 6.

## Patentansprüche

1. Leiterplattenanordnung, umfassend:
eine Leiterplatte (1);
eine Stützplatte (2), die fest mit einer Seite der Leiterplatte (1) verbunden ist, wobei die Stützplatte (2) mit einem Aufnahmeabschnitt (21) versehen ist;
ein elektronisches Element (3), das in dem Aufnahmeabschnitt (21) aufgenommen und mit der Leiterplatte (1) verbunden ist; und
einen Platte-zu-Platte-Verbinder (4), der fest mit einer Seite der Stützplatte (2) verbunden ist, die von der Leiterplatte (1) entfernt ist,
**dadurch gekennzeichnet, dass** der Aufnahmeabschnitt (21) eine auf der Stützplatte (2) bereitgestellte Durchkontaktierung ist, und die Durchkontaktierung entlang einer Höhenrichtung der Leiterplattenanordnung hindurch verläuft; und
der Platte-zu-Platte-Verbinder (4) die Durchkontaktierung abdeckt.

2. Leiterplattenanordnung nach Anspruch 1, ferner umfassend ein erstes Lötauge (5), wobei das elektronische Element (3) unter Verwendung des ersten Lötauges (5) an der Leiterplatte (1) befestigt und elektrisch damit verbunden ist.

3. Leiterplattenanordnung nach Anspruch 1, ferner umfassend ein zweites Lötauge (6), wobei der Platte-zu-Platte-Verbinder (4) unter Verwendung des zweiten Lötauges (6) fest mit der Stützplatte (2) verbunden ist.

4. Leiterplattenanordnung nach Anspruch 3, wobei die Stützplatte (2) mit einer ersten Durchkontaktierung (22) versehen ist, eine Innenwand der ersten Durchkontaktierung (22) mit einer ersten Leitungsschicht (23) versehen ist, die erste Leitungsschicht (23) unter Verwendung des zweiten Lötauges (6) elektrisch mit dem Platte-zu-Platte-Verbinder (4) verbunden ist, und die erste Leitungsschicht (23) elektrisch mit der Leiterplatte (1) verbunden ist.

5. Leiterplattenanordnung nach Anspruch 4, wobei die Leiterplatte (1) mit einer zweiten Durchkontaktierung (11) versehen ist, und eine Innenwand der zweiten Durchkontaktierung (11) mit einer zweiten Leitungsschicht (12) versehen ist; und
wobei die zweite Leitungsschicht (12) elektrisch mit dem elektronischen Element (3) verbunden ist.

6. Leiterplattenanordnung nach Anspruch 5, wobei die Leiterplatte (1) mit einer dritten Durchkontaktierung (13) versehen ist, und die dritte Durchkontaktierung (13) mit der ersten Durchkontaktierung (22) kommuniziert;
wobei eine Innenwand der dritten Durchkontaktierung (13) mit einer dritten Leitungsschicht (14) versehen ist, und die dritte Leitungsschicht (14) elektrisch mit der ersten Leitungsschicht (23) verbunden ist; und
wobei die Leiterplatte (1) ferner mit einer vierten Leitungsschicht (15) versehen ist, und die vierte Leitungsschicht (15) elektrisch mit der dritten Leitungsschicht (14) und der zweiten Leitungsschicht (12) separat verbunden ist.

7. Elektronische Vorrichtung, umfassend mehr als zwei Leiterplattenanordnungen, wobei jede der mehr als zwei Leiterplattenanordnungen einen Platte-zu-Platte-Verbinder umfasst, wobei die mehr als zwei Leiterplattenanordnungen unter Verwendung jeweiliger Platte-zu-Platte-Verbinder verbunden sind, und mindestens eine Leiterplattenanordnung die Leiterplattenanordnung nach einem der Ansprüche 1 bis 6 ist.

## Revendications

1. Ensemble carte de circuit, comprenant :
une carte de circuit (1) ;
une plaque de support (2) connectée de manière fixe à un côté de la carte de circuit (1), la plaque de support (2) étant pourvue d'une portion d'accueil (21) ;
un élément électronique (3) accueilli dans la portion d'accueil (21) et connecté à la carte de circuit (1) ; et
un connecteur carte à carte (4) connecté de manière fixe à un côté de la plaque de support (2) qui est éloigné de la carte de circuit (1),
**caractérisé en ce que** la portion d'accueil (21) est un trou d'interconnexion traversant prévu sur la plaque de support (2), et le trou d'interconnexion traversant traverse le long d'une direction de hauteur de l'ensemble carte de circuit ; et
le connecteur carte à carte (4) couvre le trou d'interconnexion traversant.

2. Ensemble carte de circuit selon la revendication 1, comprenant en outre un premier coussinet de soudure (5), dans lequel l'élément électronique (3) est assujetti et connecté électriquement à la carte de circuit (1) à l'aide du premier coussinet de soudure (5).

3. Ensemble carte de circuit selon la revendication 1, comprenant en outre un deuxième coussinet de soudure (6), dans lequel le connecteur carte à carte (4) est connecté de manière fixe à la plaque de support (2) à l'aide du deuxième coussinet de soudure (6).

4. Ensemble carte de circuit selon la revendication 3, dans lequel la plaque de support (2) est pourvue d'un premier trou d'interconnexion (22), une paroi interne du premier trou d'interconnexion (22) est pourvue d'une première couche conductrice (23), la première couche conductrice (23) est électriquement connectée au connecteur carte à carte (4) à l'aide du deuxième coussinet de soudure (6), et la première couche conductrice (23) est électriquement connectée à la carte de circuit (1).

5. Ensemble carte de circuit selon la revendication 4, dans lequel la carte de circuit (1) est pourvue d'un deuxième trou d'interconnexion (11), et une paroi interne du deuxième trou d'interconnexion (11) est pourvue d'une deuxième couche conductrice (12) ; et
la deuxième couche conductrice (12) est électriquement connectée à l'élément électronique (3).

6. Ensemble carte de circuit selon la revendication 5, dans lequel la carte de circuit (1) est pourvue d'un troisième trou d'interconnexion (13), et le troisième trou d'interconnexion (13) communique avec le premier trou d'interconnexion (22) ;
une paroi interne du troisième trou d'interconnexion (13) est pourvue d'une troisième couche conductrice (14), et la troisième couche conductrice (14) est électriquement connectée à la première couche conductrice (23) ; et
la carte de circuit (1) est en outre pourvue d'une quatrième couche conductrice (15), et la quatrième couche conductrice (15) est électriquement connectée à la troisième couche conductrice (14) et à la deuxième couche conductrice (12) de façon distincte.

7. Dispositif électronique, comprenant plus de deux ensembles cartes de circuit, chacun des plus de deux ensembles cartes de circuit comprenant un connecteur carte à carte, les plus de deux ensembles cartes de circuit étant connectés à l'aide de connecteurs carte à carte respectifs, et au moins un ensemble carte de circuit étant l'ensemble carte de circuit selon l'une quelconque des revendications 1 à 6.
